# EUROPEAN PATENT SPECIFICATION

(11) **EP 3 828 553 B1**
(45) Date of publication and mention of the grant of the patent: **15.01.2025**
(21) Application number: 19212013.7
(22) Date of filing: 28.11.2019
(51) Int. Cl.: G01R 15/04, G01R 15/06

(54) **VOLTAGE SENSOR FOR POWER NETWORKS**
SPANNUNGSSENSOR FÜR STROMNETZE
CAPTEUR DE TENSION POUR LES RÉSEAUX ÉLECTRIQUES

(43) Date of publication of application: 02.06.2021
(73) Proprietor: 3M Innovative Properties Company, Saint Paul, MN 55133-3427 (US)
(72) Inventor: Weichold, Jens, 41812 Erkelenz (DE)
(74) Representative: Müller, Bruno

(56) References cited:
- EP-A1- 3 223 024
- EP-A1- 3 364 196
- EP-A1- 3 415 928
- EP-A1- 3 462 183
- EP-A1- 3 517 982

## Description

The present disclosure relates to voltage sensors for high-voltage and medium-voltage power networks, especially to voltage sensors for sensing an elevated voltage in separable connectors.

Power networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensors in electrical installations at key locations of their network, such as in switchgears or transformers to collect information about the current state of their power network.

A rather common type of voltage sensor for this purpose comprises a voltage divider, i.e. a chain of impedance elements (resistors, capacitors or inductors), electrically serially connected between an element on the elevated voltage to be sensed and electrical ground. Such a voltage divider is described, for example, in the European patent application published as EP 3 223 024 A1. Another European patent application, EP 3 462 183 A1, relates to a MV/HV voltage sensor comprising an adapter element comprising a high voltage connection adapted to be mechanically and electrically coupled to a high voltage conductor of a separable connector.

For reliable and accurate voltage sensing it is important to mechanically and electrically connect the voltage sensor reliably to the power conductor on elevated voltage. Typically, this is done by soldering or clamping one end of a wire to the power conductor and connecting its other end to the voltage sensor. However, the power conductor on elevated voltage may be difficult to access by an installer, making a proper electrical and mechanical connection difficult. Where the connection requires manual work, such as in soldering, errors or defects may occur which may result in an unreliable connection and early failure.

In an attempt to address these issues, the present disclosure provides a voltage sensing coupling plug for sensing an elevated voltage of a high-voltage or medium-voltage separable connector in a power network of a national grid, the voltage sensing coupling plug comprising a plug body and a voltage sensor, wherein the plug body comprises i) an insulating housing forming a first elongated space for accommodating the voltage sensor and a second elongated space, extending orthogonally to the first elongated space, ii) a conductive contact piece, at least partially arranged in the second elongated space, for mechanical and electrical connection to a contact element on elevated voltage of the separable connector, and iii) a mating portion protruding from the second elongated space and shaped suitably to be mated with the separable connector;
and wherein the voltage sensor comprises a voltage divider for sensing the elevated voltage of the contact piece, the voltage divider comprising a high-voltage contact electrically and mechanically connected to the contact piece, a low-voltage contact for connection to ground, and a plurality of discrete impedance elements, electrically connected in series between the high-voltage contact and the low-voltage contact, for dividing the elevated voltage of the contact piece and providing a signal voltage varying proportionally with the elevated voltage, wherein at least a portion of the voltage divider is accommodated in the first elongated space, and wherein the plug body is adapted to receive and insulate an end of a high-voltage or medium-voltage power cable.

Generally, a coupling plug is a separable connector with a protruding mating portion which can be inserted into a rear aperture of a further separable connector where it mates with the separable connector and establishes a reliable mechanical and electrical connection with the separable connector.

Coupling plugs are standard connection elements in high-voltage and medium-voltage power networks. They facilitate reliable electrical and mechanical connection to a separable connector. Where a first power cable is connected to a bushing of a switchgear, for example, via a separable connector, a first recess at the front side of the separable connector receives a protruding portion of the bushing. The protruding mating portion of a coupling plug can be inserted into a second recess at the rear side of the separable connector to establish a secure mechanical and electrical connection of the coupling plug (and a second power cable terminated by it) to the separable connector. Thereby, a second power cable can be connected to the same bushing.

Most coupling plugs comprise a plug body which provides structural support and electrical insulation to the coupling plug. These plug bodies are shaped suitably to be easily and reliably mated with a separable connector and to facilitate a reliable electrical and mechanical connection with that separable connector. Because the plug body is adapted for mating with a corresponding separable connector in a plug-socket relationship, the electrical and mechanical connection established between the plug body and the separable connector is particularly reliable and particularly easy to install.

Plug bodies of coupling plugs are designed to provide proper electrical insulation between elevated voltage and ground. For that purpose, they comprise adequate insulating layers of adequate material and adequate thickness, geometry and conductivity. According to the present disclosure the voltage divider is accommodated in the plug body of a coupling plug. Thereby the plug body provides electrical insulation of the voltage sensor without requiring modifications or additions to the plug body.

The present disclosure relates to voltage sensing coupling plugs for use in medium-voltage ("MV") or high-voltage ("HV") power distribution networks in which electrical power is distributed via HV/MV cables, transformers, switchgears, substations etc. with currents of hundreds of amperes and voltages of tens of kilovolts. The term "medium voltage" or "MV" as used herein refers to an AC or DC voltage in the range of 1 kilovolt (kV) to 72 kV, whereas the term "high voltage" or "HV" refers to an AC or DC voltage of more than 72 kV. Medium voltage and high voltage are collectively referred to herein as "elevated voltage".

The term "plug body" as used herein refers collectively to the conductive contact piece and the insulating housing of voltage sensing coupling plugs according to the present disclosure and of traditional coupling plugs. Such coupling plugs are often shaped like the letter "T" and are commonly used to connect a second MV/HV power cable to a bushing of a switchgear or a transformer in a power network to which a first cable is already connected via a separable connector. The portion of the insulating housing of a T-shaped coupling plug corresponding to the vertical branch of the "T" forms and envelopes a first elongated space of a generally cylindrical shape. In traditional coupling plugs the first elongated space is used to accommodate the end of the second power cable which is supposed to be connected to the switchgear or transformer. In the voltage sensing coupling plug of the present disclosure, however, the first elongated space is used to accommodate the voltage divider.

The portion of the insulating housing corresponding to the horizontal branch of the "T" forms and envelopes a second elongated space. The second elongated space may be of a generally cylindrical shape, and it may have conical recesses to the left and/or the right to receive a coupling piece, a protruding portion of a bushing, or an insulation plug. Many traditional plug bodies of coupling plugs feature such a second elongated space. The length direction of the second elongated space is also referred to herein as an axial direction of the second elongated space, and directions orthogonal thereto are referred to herein as radial directions the second elongated space.

Insulating housings of plug bodies of voltage sensing coupling plugs according to the present disclosure - and plug bodies of traditional coupling plugs - are usually made of synthetic rubber such as EPDM (ethylene propylene diene monomer rubber). The insulating housing may be elastically expandable or elastically shrinkable. An expandable housing may allow to push the plug body over a cable end, while an elastically shrinkable housing may facilitate engagement with a cable end via cold-shrinking or heat-shrinking.

The insulating housing may comprise semiconductive or even conductive portions, such as a stress control element or a shielding layer or a grounding layer.

Plug bodies of traditional coupling plugs comprise a cable lug which is attached to the end of the central conductor of the power cable and which protrudes radially into the second elongated space, while the cable end is arranged in the first elongated space. The protruding portion of the cable lug usually has an aperture or a thread for attachment to a connection rod which connects the cable lug with a conductor of a bushing or of an adjacent separable connector.

In a voltage sensing coupling plug according to the present disclosure, the contact piece is used in place of the cable lug described above. A portion of the contact piece protrudes radially into the second elongated space. The protruding portion may have an aperture or a thread for attachment to a connection rod which connects the contact piece with a conductor of a bushing or a cable lug of an adjacent separable connector.

The contact piece, as the cable lug in traditional coupling plugs, serves to electrically and mechanically connect the voltage sensing coupling plug to a cable lug of a separable connector on elevated voltage, so that the voltage sensor can sense that elevated voltage of that separable connector.

The contact piece may be suitable or adapted for direct or for indirect mechanical connection with that cable lug on elevated voltage. An indirect mechanical connection refers to a connection via an intermediate conductive component.

The contact piece is electrically connected to the voltage divider such that the voltage divider is usable to sense the elevated voltage of the contact piece. For that purpose, the contact piece is electrically connected to the high-voltage portion of the voltage divider, as explained below.

Also, the high-voltage portion of the voltage divider is not only electrically, but also mechanically connected to the contact piece. This mechanical connection is an electrically conductive connection. This connection may be a direct connection, i.e. an element of the voltage divider is connected to the contact piece without any intermediate element. Alternatively, this connection may be an indirect connection, i.e. an element of the voltage divider is connected to the contact piece via an intermediate element. The plug body may thus further comprise an intermediate element which mechanically and electrically connects the voltage divider (e.g. a connection tab or a high-voltage contact of the voltage divider) with the contact piece. Such an intermediate element may be, for example, a connector, a pin, a rod, a wire, a conductive tube or the like.

By mating as understood herein, a mechanical and electrical connection is established between two mating elements, where the mechanical connection is established via matching shapes of the mating elements in a plug-socket manner, where a plug is shaped to mate with a specific type of socket, and a socket is shaped to mate with a specific type of plug.

Plug bodies and mating portions of traditional coupling plugs are designed to be mated with a separable connector. Where a traditional coupling plug is supposed to be mated with a separable connector, its mating portion is suitably shaped to mate with the separable connector on one side of the separable connector.

Plug bodies of voltage sensing coupling plugs according to this disclosure, just as of traditional coupling plugs, comprise a mating portion for the purpose of mating with a corresponding separable connector. Suitable interfaces, e.g. a Type C interface, between coupling plugs and separable connectors are, amongst others, those interfaces described, in the German standards DIN EN 50180 for bushings and DIN EN 50181 for plug-in type bushings.

The insulating housing of a plug body in a voltage sensing coupling plug according to the present disclosure is an insulating housing of a common plug body as used in traditional coupling plugs. The mating portion of a plug body in a voltage sensing coupling plug according to the present disclosure may be identical with a mating portion of a plug body of a traditional coupling plug, e.g. one as described above. The mating portion of a plug body in a voltage sensing coupling plug according to the present disclosure may be adapted to form, with the separable connector to which it is connected, a type A1, type B1, type B2, type C1 or type C2 interface as described, for example, in German standards DIN EN 50180 and 50181.

A voltage sensor of a voltage sensing coupling plug according to this disclosure comprises a voltage divider. As is usual with voltage dividers, the voltage divider is electrically connected between the elevated voltage and electrical ground. The discrete impedance elements of the voltage divider are electrically connected in series with each other. The voltage divider comprises a signal contact for picking up a divided voltage (the "signal voltage") from the plurality of discrete impedance elements. The signal voltage is a voltage that varies proportionally with the elevated voltage. The signal contact is electrically arranged between two discrete impedance elements of the plurality of discrete impedance elements. A signal wire may be electrically connected to the signal contact for transmitting the signal voltage to outside of the plug body and outside of the voltage sensing coupling plug.

In a voltage sensor of a voltage sensing coupling plug according to this disclosure, the elevated voltage is divided by a plurality of serially connected discrete impedance elements, so that the voltage "behind" each impedance element is lower than "before" it. Where the number of serially-connected impedance elements is greater, the elevated voltage is divided down in more steps. This allows the voltage drop across each impedance element to be smaller, so that there is less electrical stress on each impedance element, which makes the voltage sensor more reliable. For elevated voltages of tens of kilovolt (kV) it is advantageous to use ten or more discrete impedance elements for forming the voltage divider of the voltage sensor. Therefore, in certain embodiments, the plurality of discrete impedance elements consists of ten or more discrete impedance elements, e.g. of ten or more discrete capacitors, or of ten or more discrete resistors, or of ten or more discrete inductors.

Generally, the number of discrete impedance elements is per se not limited, the minimum being one discrete impedance element. The high-voltage portion of the voltage divider may comprise one, two or more discrete impedance elements. The low-voltage portion of the voltage divider may comprise one, two or more discrete impedance elements.

The plurality of discrete impedance elements may be mechanically connected in series, e.g. such as to form a chain. The plurality of discrete impedance elements may be electrically connected with each other by wires or by conductive traces on a PCB or by soldering material. Each discrete impedance element may comprise two contacts for connecting it electrically to other impedance elements or to the ground contact or to the voltage contact.

The voltage sensor has a high-voltage contact for connection of the voltage sensor, and of the voltage divider, to the contact piece, which is on elevated voltage when in use. The voltage sensor also has a low-voltage contact for connection of the voltage sensor, and of the voltage divider, to ground. The plurality of discrete impedance elements is electrically connected between the high-voltage contact and the low-voltage contact. Thereby, the voltage sensor can sense the voltage between the voltage contact and the low-voltage contact, i.e. it can sense the elevated voltage of the contact piece versus ground.

Of the plurality of discrete impedance elements, those discrete impedance elements which are electrically arranged between the high-voltage contact and the signal contact are collectively referred to herein as the high-voltage portion of the voltage divider, and those discrete impedance elements which are electrically arranged between the low-voltage contact and the signal contact are collectively referred to herein as the low-voltage portion of the voltage divider.

Generally, in the context of the present disclosure, the term "impedance element" refers to a capacitor, a resistor, or an inductor. An impedance element, i.e. a capacitor, a resistor, or an inductor, may be a discrete impedance element, i.e. a discrete capacitor, a discrete resistor, or a discrete inductor. As used herein, a discrete impedance element is an individual impedance element that exists independently from other impedance elements, from a printed circuit board ("PCB") or from conductive traces on a PCB. In particular, a discrete impedance element is not formed by conductive traces on an outer surface of a PCB, or in a PCB. A discrete impedance element may be, in particular, a surface mount discrete impedance element, i.e. one that can be mounted on an outer surface of a PCB.

In certain embodiments, each impedance element comprised in the high-voltage portion and/or in the low-voltage portion is a discrete, surface-mount impedance element. In certain of these embodiments, each impedance element comprised in the high-voltage portion and/or in the low-voltage portion is a discrete, surface mount capacitor. Discrete surface-mount capacitors of suitable capacitances in the nanofarad and picofarad range are commercially available at high nominal precision ratings and are therefore useful in voltage dividers usable in voltage sensing coupling plugs according to the present disclosure. Also, discrete surface-mount capacitors can be replaced more easily.

The term "accommodated in" the first or second elongated space is understood to be synonymous with being received in, or being arranged inside, the first or second elongated space, respectively.

In certain embodiments the mating portion and the insulating housing of a voltage sensing coupling plug as described herein are a single piece, which may result in lower manufacturing cost. In certain other embodiments the mating portion is separate from the insulating housing and accommodated in the second elongated space. This may make manufacturing and/or assembly of the voltage sensing coupling plug easier and more cost-effective. Also, this may allow to more easily provide the - otherwise same - coupling plug with different mating portions, which may make the voltage sensing coupling plug mateable with different types of separable connectors.

In certain embodiments the mating portion is adapted to be used in a type A1, B1, B2, C1 or C2 interface according to German standards DIN EN 50180 or DIN EN 50181, as in force on 18 November 2019. A mating portion that conforms to an industry standard or to a de-facto standard may render the coupling plug of the present disclosure mateable with more types of separable connectors and thus be more versatile.

The voltage sensor preferably has an elongated shape. With an elongated shape, the high-voltage portion of the voltage divider can be arranged at a maximum distance from the low-voltage portion of the voltage divider, and each discrete impedance element can be arranged at a maximum distance from adjacent neighbouring impedance elements. In preferred embodiments, the discrete impedance elements of the voltage divider are geometrically arranged as a straight chain of impedance elements, e.g. a straight chain arranged on a printed circuit board (PCB). In preferred embodiments the voltage divider comprises ten or more discrete impedance elements. In such embodiments the voltage sensor may have a strongly elongated shape, in which its length is greater than three times, five times or even ten times its diameter. "Diameter" refers, in this context, to its largest extension in a cross section taken orthogonally to the length direction at any length position of the voltage sensor.

A voltage sensor that has an elongated shape can be accommodated more easily and in a more space saving manner in a space that also has an elongated shape. Therefore, in certain embodiments of the voltage sensing coupling plug the first elongated space is shaped such that its length is greater than three times its diameter.

The voltage divider may be encapsulated in a rigid, electrically insulating encapsulation body. The encapsulation body may, for example, be made of an epoxy resin which is cast in liquid form around the discrete impedance elements of the voltage divider and - if present - around the circuit board on which the impedance elements are supported. The resin is then let dry and harden to form the rigid encapsulation body. The encapsulation body may help reduce the risk of electrical discharges between individual discrete impedance elements and/or between the high-voltage portion and the low-voltage portion of the voltage divider, and/or between the high-voltage portion and other elements on electrical ground. Hence in certain embodiments the voltage sensing coupling plug further comprises a rigid, non-conductive encapsulation body encapsulating the plurality of discrete impedance elements.

The encapsulation body may be provided with a conductive shielding layer, arranged on a portion of an outer surface of the encapsulation body, or arranged on an outer surface of the encapsulation body. The shielding layer may be held on electrical ground or on elevated voltage. The shielding layer may help in reducing parasitic currents from the discrete impedance elements which would reduce the measurement accuracy of the voltage sensor. Therefore, in certain embodiments, the voltage sensing coupling plug according to the present disclosure further comprises a conductive shielding layer, arranged on an outer surface of the encapsulation body.

The voltage sensor - with the voltage divider encapsulated in an encapsulation body as described above or not encapsulated - may be accommodated in a tubular insulating sleeve. The insulating sleeve may be elastically deformable. It may, for example, be made of, or comprise, a non-conductive silicone rubber material. The sleeve may surround the encapsulation body and the voltage sensor. The sleeve may be a shrinkable sleeve. It may be held in an expanded state to receive the non-encapsulated voltage sensor or the encapsulation body encapsulating the voltage sensor, and may then be shrunk down on the voltage sensor or on the encapsulation body . After shrinking on an encapsulation body the sleeve may be in tight surface contact with the outer surface of the encapsulation body and, if available, the shielding layer. The sleeve may comprise semiconductive stress control elements which contact a shielding layer at its respective edges to avoid a high concentration of field lines at the edges and reduce the risk of electrical discharge at those edges. Hence in certain embodiments a voltage sensing coupling plug according to the present disclosure further comprises a tubular, elastically deformable insulating sleeve in which sleeve the voltage sensor is embedded.

The plug body of a voltage sensing coupling plug according to the present disclosure may be a plug body of a regular, traditional coupling plug by which an end of a MV/HV power cable can be connected to a separable connector. Such a traditional coupling plug has a first elongated space to receive an end of a high-voltage or medium-voltage power cable. In the voltage sensing coupling plug according to the present disclosure, the first elongated space is adapted to receive an end of a high-voltage or medium-voltage power cable. In certain of these embodiments the plug body is a plug body of a traditional coupling plug, used to connect an end of a MV/HV power cable to a separable connector.

The plug body of the voltage sensing coupling plug is adapted to receive and insulate an end of a high-voltage or medium-voltage power cable. A plug body that is adapted to receive and insulate an end of a power cable may be particularly suitable to receive and insulate a voltage sensor accommodated in its first elongated space. Also, such plug bodies may be more readily available, and potentially at lower cost, than plug bodies which are particularly tailored to receive and insulate a voltage sensor of a voltage sensing coupling plug according to the present disclosure.

In certain embodiments, the first elongated space may be adapted to accommodate, further to at least a portion of the voltage divider, a high-voltage or medium-voltage power cable or an end of such a high-voltage or medium-voltage power cable. However, in preferred embodiments, the first elongated space is free of an end of a high-voltage or medium-voltage power cable. This may facilitate the use of a plug body of a traditional coupling plug as a plug body of a voltage sensing coupling plug according to the present disclosure, potentially resulting in lower cost.

In certain embodiments the first elongated space is in communication with the second elongated space. In other words, the first and the second elongated spaces are connected. This may make installation of the voltage sensor in the first elongated space easier, because air may escape from the first elongated space into the second elongated space when the voltage sensor is pushed into the first elongated space.

In certain preferred embodiments, the signal wire exits the plug body through an aperture at an end portion of the first elongated space, far from the contact piece on elevated voltage. This helps to reduce the risk of electrical discharge between the elevated voltage and the signal wire, which is on a low voltage. Therefore, in certain embodiments, the first elongated space is in communication with an outside of the plug body, and a signal wire makes the signal voltage available outside of the plug body, the signal wire leading from the first elongated space to the outside of the plug body.

In voltage sensing coupling plugs according to the present disclosure, at least a portion of the voltage divider is accommodated in the first elongated space. In certain embodiments, the entire voltage divider, including the high-voltage portion, the signal contact and the low-voltage portion of the voltage divider, is accommodated in the first elongated space. In these embodiments the voltage divider is completely accommodated in the first elongated space. This may be advantageous to reduce the risk of electrical discharges and to protect the voltage divider against environmental impacts or reduce the risk of its mechanical deformation.

In other embodiments, only a portion of the voltage divider is accommodated in the first elongated space. In certain of these embodiments, the high-voltage portion is accommodated in the first elongated space, i.e. completely accommodated in the first elongated space. This may help reduce the risk of electrical discharges from the high-voltage portion.

In certain ones of those embodiments the low-voltage portion is partially accommodated in the first elongated space. In certain other ones of those embodiments the low-voltage portion (i.e. the entire low-voltage portion) is arranged outside the first elongated space. These designs may help keep the plug body shorter and thereby reduce its manufacturing cost.

In certain embodiments the contact piece protrudes into the first elongated space. This may facilitate external access to the contact piece, so that it can be easier connected to a contact element of the separable connector, e.g. by accessing the contact piece via the second elongated space.

In certain of those embodiments the contact piece is externally accessible via the second elongated space. Again, this may be an advantageous way of allowing mechanical and electrical connections to the contact piece, thereby potentially reducing installation time of a voltage sensing coupling plug of the present disclosure to a separable connector.

The voltage sensing coupling plug according to the present disclosure may advantageously be used with a separable connector connected to a switchgear or a transformer in a high-voltage or medium-voltage power network of a national grid, facilitating accurate voltage sensing of the separable connector. The present disclosure therefore also provides an assembly comprising a) a switchgear or a transformer in a high-voltage or medium-voltage power network of a national grid, the switchgear or transformer comprising a bushing; b) a high-voltage or medium-voltage separable connector, electrically and mechanically connected to the switchgear or transformer via the bushing; and c) a voltage sensing coupling plug as described herein, mated with the separable connector.

The present disclosure further provides a power network, such as a national grid, comprising an assembly as described in the preceding paragraph. The present disclosure further provides a power network, such as a national grid, comprising a voltage sensing coupling plug as described herein.

The invention will now be described in more detail with reference to the following Figures exemplifying particular embodiments of the invention:
- Fig. 1: Electrical circuit diagram of a voltage divider, usable in a voltage sensing coupling plug according to the present disclosure;
- Fig. 2: Cross section of a voltage sensing coupling plug according to the present disclosure and of a separable connector connected to a bushing; and
- Fig. 3: Voltage sensor usable in a voltage sensing coupling plug according to the present disclosure.

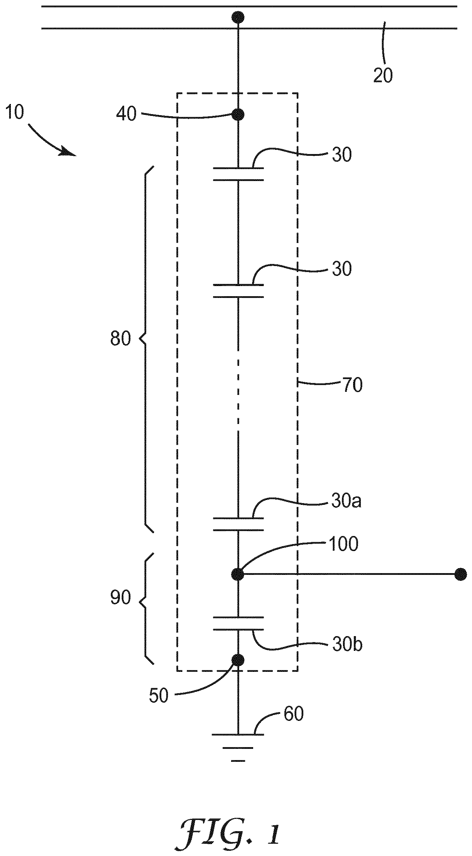

In the circuit diagram of **Figure 1****,** a voltage sensor 10 is shown electrically connected to a power conductor 20 on elevated voltage. The voltage sensor 10 comprises a plurality of discrete capacitors 30, which are electrically connected in series between a high-voltage contact 40 and a low-voltage contact 50. The high-voltage contact 40 facilitates connection to the power conductor 20 on elevated voltage, while the low-voltage contact 50 facilitates connection to electrical ground 60. The discrete impedance elements 30 are operable as a voltage divider 70, indicated as a dashed box, for sensing the elevated voltage of the conductor 20, as they divide the elevated voltage down to electrical ground 60. The voltage divider 70 comprises the plurality of discrete dividing capacitors 30, which are electrically connected in series with each other such that the voltage divider 70 can sense the elevated voltage of the power conductor 20. A subset of the capacitors 30, 30a, connected to the elevated voltage, form a high-voltage portion 80 of the voltage divider 70, with a low-voltage portion 90 being formed by a single discrete capacitor 30b. Alternatively, the low-voltage portion 90 could be formed by two or more discrete capacitors 30b, electrically connected in series or parallel, to obtain a specific combined capacitance.

A signal contact 100 is connected electrically between the high-voltage portion 80 and the low-voltage portion 90. At the signal contact 100, a divided voltage, also referred to herein as the signal voltage, can be picked up, which varies proportionally with the elevated voltage of the power conductor 20. The proportionality factor between the elevated voltage and the signal voltage depends on the ratio of the total impedance of the high-voltage portion 80 to the total impedance of the low-voltage portion 90 of the voltage divider 70. By measuring the signal voltage of the signal contact 100, the elevated voltage of the power conductor 20 can be sensed.

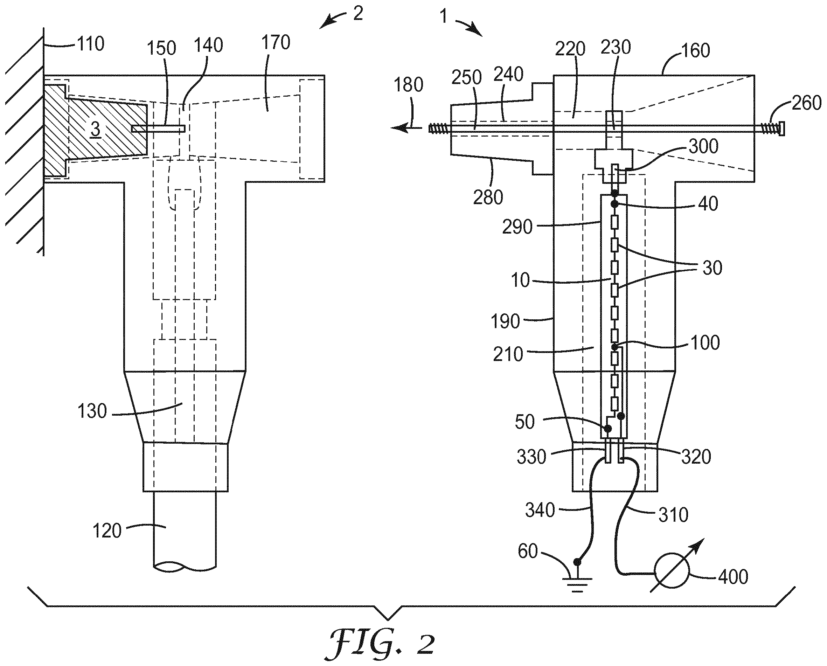

**Figure 2** is a cross-sectional view of a voltage sensing coupling plug 1 according to the present disclosure, a separable connector 2 connected to a bushing 3 of a switchgear 110 in a power network of a national grid. The separable connector 2 connects a medium-voltage power cable 120 via the bushing 3 to the switchgear 110. In use, a cable conductor 130 of the power cable 120 is on elevated voltage. A contact element 140, namely a cable lug 140, is crimped onto the end of the cable conductor 130, and a bolt 150 electrically and mechanically connects the lug 140 to a conductor (not shown) of the bushing 3.

The voltage sensing coupling plug 1 is shown before mating with the separable connector 2. It can be mated electrically and mechanically by inserting it in an insertion direction, indicated by arrow 180, into a rear aperture 170 of the separable connector 2, in a plug-socket manner, and engaging a conductive bolt 250 (not shown) between the contact element 140 of the separable connector 2 and the contact piece 230 of the voltage sensing coupling plug 1. Once mated with the separable connector 2, the voltage sensing coupling plug 1 can sense the elevated voltage of the separable connector 2, i.e. the elevated voltage at the cable lug 140 of the separable connector 2.

The voltage sensing coupling plug 1 generally comprises a plug body 160 and a voltage sensor 10. The plug body 160, in turn, features an insulating housing 190 of a non-conductive synthetic rubber material which forms and envelopes a first elongated space 210, in which the voltage sensor 10 is accommodated, and a second elongated space 220. The length direction of the first elongated space 210 extends vertically (in Figure 2), while the length direction of the second elongated space 220 extends orthogonally thereto, namely horizontally (in Figure 2), in direction of the arrow 180. In traditional coupling plugs, which have a comparable shape, the first elongated space 210 is used to accommodate a cable end. In the voltage sensing coupling plug 1 according to the present disclosure, however, no cable end is present in the first elongated space 210, and the first elongated space 210 is used exclusively to accommodate the voltage sensor 10.

In the voltage sensing coupling plug 1, a conductive contact piece 230 protrudes into the second elongated space 220. It is mechanically and electrically connected to the voltage sensor 10 in the plug body 160. An aperture in the contact piece 230, arranged in a portion of the contact piece 230 protruding into the second elongated space 220, facilitates a secure electrical and mechanical connection to the contact element 140 of the separable plug 2, when the voltage sensing coupling plug 1 is mated with the separable connector 2. For example, a conductive threaded bolt 250 can be attached to the contact piece 230 such that it extends through a passageway 240 into the rear aperture 170 of the separable connector 2 such that it can be engaged with the contact element 140 on elevated voltage. The threaded bolt 250 extends through the second elongated space 220 and can be turned at its rear end 260. Once engaged, a shear-off mechanism can release the rear portion of the threaded bolt 250 from a remaining portion which continues to connect the contact piece 230 with the contact element 140.

For facilitating a plug-type mating connection with the separable connector 2, the plug body 160 comprises a mating portion 280 which protrudes from the second elongated space 220. Its conically protruding shape corresponds precisely to the conically recessing shape of the rear aperture 170 of the separable connector 2, so that after mating the number and size of air pockets between the mating portion 280 and walls of the rear aperture 170 is minimal.

The voltage sensor 10 of the voltage sensing coupling plug 1 with its voltage divider 70 is accommodated completely in the first elongated space 210. Its electrical circuit layout is identical to the circuit layout of the voltage sensor 10 shown in Figure 1. The discrete capacitors 30 are arranged on a PCB 290. The high-voltage portion 80 is electrically connected to the contact piece 230 by a conductive input tab 300, soldered to the contact piece 230 and the high-voltage contact 40, respectively. A signal wire 310 is electrically connected to the signal contact 100 via conductive traces on the PCB 290 and via a signal tab 320 of the voltage sensor 10, and is led to outside the plug body 160 to make the signal voltage available outside the plug body 160, for example to a processing device 400 which measures the signal voltage and determines the elevated voltage from the signal voltage. The voltage sensor 10 is provided with a connection to electrical ground 60 via the low-voltage contact 50, a ground tab 330 of the voltage sensor 10 and a grounding wire 340, which is also led to outside the plug body 160.

In alternative embodiments only a portion of the voltage sensor 10, e.g. a portion in the vicinity of the high-voltage portion 80 of the voltage divider 70, may be accommodated in the first elongated space 210, while another portion, e.g. a portion in the vicinity of the low-voltage portion 90 of the voltage divider 70, may not be accommodated in the first elongated space 210, but, for example, protrude to an outside of the insulating housing 190 of the plug body 160.

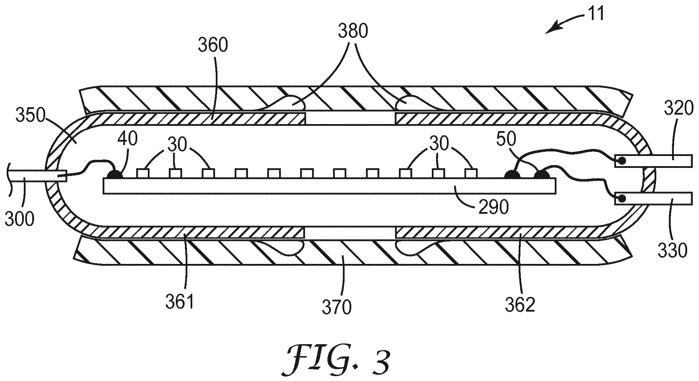

The voltage sensor 10 in Figure 2 may be protected against environmental impacts by encapsulating it in an encapsulation body. Such an alternative voltage sensor 11, usable in voltage sensing coupling plugs according to the present invention, is shown in **Figure 3** in a sectional view. In this voltage sensor 11, the discrete impedance elements 30 are again arranged on a PCB 290, and the electrical circuit is similar to the circuitry shown in Figures 1 and 2. The voltage sensor 11 is embedded in a rigid, electrically insulating encapsulation body 350. The encapsulation body 350 is made of an epoxy resin which is cast in liquid form around the discrete impedance elements 30 of the voltage sensor 11 and the circuit board 290 on which the impedance elements 30 are supported and is then let dry and harden to form the rigid encapsulation body 350. The encapsulation body 350 is illustrated as transparent for greater clarity, but may be transparent, translucent, or opaque. For sensing the elevated voltage, the voltage sensor 11 is electrically connected to the contact piece 230 on elevated voltage via a high-voltage contact 40 and to ground via a low-voltage contact 50. A signal tab 320 makes the signal voltage available outside of the encapsulation body 350.

The outer surface of the encapsulation body 350 is equipped with a split shielding 360 to reduce parasitic currents. The split shielding 360 comprises two conductive shielding layers 361, 362, arranged side by side on respective portions of the outer surface of the encapsulation body 350. Each of these layers 361, 362 surrounds a number of discrete impedance elements 30 of the voltage sensor 11.

The first, left-hand shielding layer 361 is connected to the elevated voltage, while the second, right-hand shielding layer 362 is held on electrical ground. This minimizes parasitic currents from the impedance elements 30, which may reduce the accuracy of the voltage sensing.

To provide electrical insulation to the voltage sensor 11 and to reduce the risk of electrical discharges between elements of the voltage sensor 11 and elements of the plug body 160, the voltage sensor 11 in its encapsulation body 350 is accommodated in a tubular, elastically deformable insulating sleeve 370, made of a non-conductive silicone rubber material. The sleeve 370 surrounds the encapsulation body 350 and the voltage sensor 11. The sleeve 370 is a shrinkable sleeve 370, which was held in an expanded state to receive the encapsulation body 350 encapsulating the voltage sensor 11 and was then shrunk down on the encapsulation body 350. After shrinking, as shown in Figure 3, the sleeve 370 is in tight surface contact with the outer surface of the encapsulation body 350 and the shielding 360. The sleeve 370 comprises semiconductive stress control elements 380 which contact the shielding layers 361, 362 at their respective edges to avoid a high concentration of field lines at the edges and reduce the risk of electrical discharge at those edges.

In a voltage sensing coupling plug according to the present disclosure, the voltage sensor 11 is accommodated in the first elongated space 210 of the plug body 160, similar to how the voltage sensor 10 is accommodated in the first elongated space 210 of the plug body 160 shown in Figure 2.

## Claims

1. Voltage sensing coupling plug (1) for sensing an elevated voltage of a high-voltage or medium-voltage separable connector (2) in a power network of a national grid, the voltage sensing coupling plug comprising a plug body (160) and a voltage sensor (10, 11),
wherein the plug body comprises
i) an insulating housing (190) forming a first elongated space (210) for accommodating the voltage sensor (10, 11) and a second elongated space (220), extending orthogonally to the first elongated space (210),
ii) a conductive contact piece (230), at least partially arranged in the second elongated space (220), for mechanical and electrical connection to a contact element (140) on elevated voltage of the separable connector (2), and
iii) a mating portion (280) protruding from the second elongated space (220) and shaped suitably to be mated with the separable connector (2);
and wherein the voltage sensor (10, 11) comprises a voltage divider (70) for sensing the elevated voltage of the contact piece (230), the voltage divider comprising
- a high-voltage contact (40) electrically and mechanically connected to the contact piece (230),
- a low-voltage contact (50) for connection to ground (60), and
- a plurality of discrete impedance elements (30), electrically connected in series between the high-voltage contact (40) and the low-voltage contact (50), for dividing the elevated voltage of the contact piece and providing a signal voltage varying proportionally with the elevated voltage,
wherein at least a portion of the voltage divider (70) is accommodated in the first elongated space (210),
**characterized in that** the plug body (160) is adapted to receive and insulate an end of a high-voltage or medium-voltage power cable (120).

2. Voltage sensing coupling plug (1) according to claim 1, wherein the mating portion (280) is separate from the insulating housing (190) and accommodated in the second elongated space (220).

3. Voltage sensing coupling plug (1) according to any one of the preceding claims, wherein the mating portion (280) is adapted to be used in a type A1, B1, B2, C1 or C2 interface according to German standards DIN EN 50180 or DIN EN 50181, as in force on 18 November 2019.

4. Voltage sensing coupling plug (1) according to any one of the preceding claims, wherein the first elongated space (210) is shaped such that its length is greater than three times its diameter.

5. Voltage sensing coupling plug (1) according to any one of the preceding claims, wherein the first elongated space (210) is adapted to receive an end of a high-voltage or medium-voltage power cable (120).

6. Voltage sensing coupling plug (1) according to any one of the preceding claims, wherein the first elongated space (210) is free of an end of a high-voltage or medium-voltage power cable (120).

7. Voltage sensing coupling plug (1) according to any one of the preceding claims, wherein the first elongated space (210) is in communication with the second elongated space (220).

8. Voltage sensing coupling plug (1) according to any one of the preceding claims, wherein the first elongated space (210) is in communication with an outside of the plug body (160), and wherein a signal wire (310) makes the signal voltage available outside of the plug body (160), the signal wire leading from the first elongated space (210) to the outside of the plug body (160).

9. Voltage sensing coupling plug (1) according to any one of the preceding claims, wherein the voltage divider (70) is completely accommodated in the first elongated space (210).

10. Voltage sensing coupling plug (1) according to any one of the preceding claims, wherein the contact piece (230) protrudes into the first elongated space (210).

11. Voltage sensing coupling plug (1) according to any one of the preceding claims, wherein the contact piece (230) is externally accessible via the second elongated space (220).

12. Voltage sensing coupling plug (1) according to any one of the preceding claims, wherein the plurality of discrete impedance elements (30) consists of ten or more discrete capacitors (30), or of ten or more discrete resistors, or of ten or more discrete inductors.

13. Voltage sensing coupling plug (1) according to any one of the preceding claims, further comprising a rigid, non-conductive encapsulation body (350) encapsulating the plurality of discrete impedance elements (30).

14. Voltage sensing coupling plug (1) according to claim 13, further comprising a conductive shielding layer (360), arranged on an outer surface of the encapsulation body (350).

15. Voltage sensing coupling plug (1) according to any one of the preceding claims, further comprising a tubular, elastically deformable insulating sleeve (370), in which sleeve (370) the voltage sensor (11) is embedded.

16. Assembly comprising
a) a switchgear (110) or a transformer in a high-voltage or medium-voltage power network of a national grid, the switchgear or transformer comprising a bushing (3);
b) a high-voltage or medium-voltage separable connector (2), electrically and mechanically connected to the switchgear or transformer via the bushing; and
c) a voltage sensing coupling plug (1) according to any one of the preceding claims, mated with the separable connector.

17. Power network, such as a national grid, comprising an assembly according to claim 16.

## Patentansprüche

1. Spannungsabtaster-Kupplungsstecker (1) zum Abtasten einer erhöhten Spannung eines Hochspannungs- oder Mittelspannungs-Trennverbinders (2) in einem Leistungsnetz eines Verbundnetzes, der Spannungsabtaster-Kupplungsstecker aufweisend einen Steckerkörper (160) und einen Spannungssensor (10, 11),
wobei der Steckerkörper aufweist
i) ein Isoliergehäuse (190), das einen ersten länglichen Raum (210) zum Aufnehmen des Spannungssensors (10, 11) und einen zweiten länglichen Raum (220) ausbildet, der sich orthogonal zu dem ersten länglichen Raum (210) erstreckt,
ii) ein leitfähiges Kontaktstück (230), das mindestens teilweise in dem zweiten länglichen Raum (220) für eine mechanische und elektrische Verbindung mit einem Kontaktelement (140) bei erhöhter Spannung des Trennverbinders (2) angeordnet ist, und
iii) einen Gegenabschnitt (280), der aus dem zweiten länglichen Raum (220) vorsteht und geeignet geformt ist, um mit dem Trennverbinder (2) in Eingriff zu stehen;
und wobei der Spannungssensor (10, 11) einen Spannungsteiler (70) zum Abtasten der erhöhten Spannung des Kontaktstücks (230) aufweist, der Spannungsteiler aufweisend
- einen Hochspannungskontakt (40), der mit dem Kontaktstück (230) elektrisch und mechanisch verbunden ist,
- einen Niederspannungskontakt (50) für eine Verbindung mit der Erdung (60), und
- eine Mehrzahl von diskreten Impedanzelementen (30), die in Reihe zwischen dem Hochspannungskontakt (40) und dem Niederspannungskontakt (50) zum Teilen der erhöhten Spannung des Kontaktstücks und Bereitstellen einer Signalspannung, die proportional zu der erhöhten Spannung variiert, elektrisch verbunden sind,
wobei mindestens ein Abschnitt des Spannungsteilers (70) in dem ersten länglichen Raum (210) untergebracht ist,
**dadurch gekennzeichnet, dass** der Steckerkörper (160) angepasst ist, um ein Ende eines Hochspannungs- oder Mittelspannungskabels (120) aufzunehmen und zu isolieren.

2. Spannungsabtaster-Kupplungsstecker (1) nach Anspruch 1, wobei der Gegenabschnitt (280) von dem Isoliergehäuse (190) getrennt ist und
in dem zweiten länglichen Raum (220) untergebracht ist.

3. Spannungsabtaster-Kupplungsstecker (1) nach einem der vorstehenden Ansprüche, wobei der Gegenabschnitt (280) angepasst ist, um in einer Schnittstelle vom Typ A1, B1, B2, C1 oder C2 gemäß den deutschen Normen DIN EN 50180 oder DIN EN 50181 in der am 18. November 2019 gültigen Fassung, verwendet zu werden.

4. Spannungsabtaster-Kupplungsstecker (1) nach einem der vorstehenden Ansprüche, wobei der erste längliche Raum (210) derart geformt ist, dass seine Länge größer als das Dreifache seines Durchmessers ist.

5. Spannungsabtaster-Kupplungsstecker (1) nach einem der vorstehenden Ansprüche, wobei der erste längliche Raum (210) angepasst ist, um ein Ende eines Hochspannungs- oder Mittelspannungskabels (120) aufzunehmen.

6. Spannungsabtaster-Kupplungsstecker (1) nach einem der vorstehenden Ansprüche, wobei der erste längliche Raum (210) frei von einem Ende eines Hochspannungs- oder Mittelspannungskabels (120) ist.

7. Spannungsabtaster-Kupplungsstecker (1) nach einem der vorstehenden Ansprüche, wobei der erste längliche Raum (210) mit dem zweiten länglichen Raum (220) in Verbindung steht.

8. Spannungsabtaster-Kupplungsstecker (1) nach einem der vorstehenden Ansprüche, wobei der erste längliche Raum (210) mit einer Außenseite des Steckerkörpers (160) in Verbindung steht, und wobei ein Signaldraht (310) die Signalspannung außerhalb des Steckerkörpers (160) verfügbar macht, wobei der Signaldraht von dem ersten länglichen Raum (210) zu der Außenseite des Steckerkörpers (160) führt.

9. Spannungsabtaster-Kupplungsstecker (1) nach einem der vorstehenden Ansprüche, wobei der Spannungsteiler (70) vollständig in dem ersten länglichen Raum (210) untergebracht ist.

10. Spannungsabtaster-Kupplungsstecker (1) nach einem der vorstehenden Ansprüche, wobei das Kontaktstück (230) in den ersten länglichen Raum (210) hineinragt.

11. Spannungsabtaster-Kupplungsstecker (1) nach einem der vorstehenden Ansprüche, wobei das Kontaktstück (230) über den zweiten länglichen Raum (220) von außen zugänglich ist.

12. Spannungsabtaster-Kupplungsstecker (1) nach einem der vorstehenden Ansprüche, wobei die Mehrzahl von diskreten Impedanzelementen (30) aus zehn oder mehr diskreten Kondensatoren (30) oder aus zehn oder mehr diskreten Widerständen oder aus zehn oder mehr diskreten Induktoren besteht.

13. Spannungsabtaster-Kupplungsstecker (1) nach einem der vorstehenden Ansprüche, ferner aufweisend einen starren, nicht leitfähigen Einkapselungskörper (350), der die Mehrzahl von diskreten Impedanzelementen (30) umkapselt.

14. Spannungsabtaster-Kupplungsstecker (1) nach Anspruch 13, ferner aufweisend eine leitfähige Abschirmschicht (360), die auf einer Außenoberfläche des Einkapselungskörpers (350) angeordnet ist.

15. Spannungsabtaster-Kupplungsstecker (1) nach einem der vorstehenden Ansprüche, ferner aufweisend eine röhrenförmige, elastisch verformbare Isolierhülse (370), in deren Hülse (370) der Spannungssensor (11) eingebettet ist.

16. Baugruppe, aufweisend
a) eine Schaltanlage (110) oder einen Transformator in einem Hochspannungs- oder Mittelspannungsnetz eines Verbundnetzes, die Schaltanlage oder der Transformator aufweisend eine Durchführung (3);
b) einen Hochspannungs- oder Mittelspannungs-Trennverbinder (2), der über die Durchführung und mechanisch mit der Schaltanlage oder dem Transformator elektrisch verbunden ist; und c) einen Spannungsabtaster-Kupplungsstecker (1) nach einem der vorstehenden Ansprüche, der mit dem Trennverbinder verbunden ist.

17. Leistungsnetz, wie ein Verbundnetz, aufweisend eine Baugruppe nach Anspruch 16.

## Revendications

1. Fiche de couplage de détection de tension (1) permettant de détecter une tension élevée d'un connecteur séparable haute tension ou moyenne tension (2) dans un réseau électrique d'un réseau national, la fiche de couplage de détection de tension comprenant un corps de fiche (160) et un capteur de tension (10, 11),
dans laquelle le corps de fiche comprend
i) un boîtier isolant (190) formant un premier espace allongé (210) pour loger le capteur de tension (10, 11) et un second espace allongé (220), s'étendant orthogonalement au premier espace allongé (210),
ii) une pièce de contact conductrice (230), au moins partiellement agencée dans le second espace allongé (220), pour une connexion mécanique et électrique à un élément de contact (140) à tension élevée du connecteur séparable (2), et
iii) une partie d'accouplement (280) faisant saillie à partir du second espace allongé (220) et conçue pour être accouplée au connecteur séparable (2) ;
et dans laquelle le capteur de tension (10, 11) comprend un diviseur de tension (70) pour détecter la tension élevée de la pièce de contact (230), le diviseur de tension comprenant
- un contact haute tension (40) connecté électriquement et mécaniquement à la pièce de contact (230),
- un contact basse tension (50) pour la connexion à la terre (60), et
- une pluralité d'éléments d'impédance discrets (30), connectés électriquement en série entre le contact haute tension (40) et le contact basse tension (50), pour diviser la tension élevée de la pièce de contact et fournir une tension de signal variant proportionnellement à la tension élevée,
dans laquelle au moins une partie du diviseur de tension (70) est logée dans le premier espace allongé (210),
**caractérisée en ce que** le corps de fiche (160) est adapté pour recevoir et isoler une extrémité d'un câble d'alimentation haute tension ou moyenne tension (120).

2. Fiche de couplage de détection de tension (1) selon la revendication 1, dans laquelle la partie d'accouplement (280) est séparée du boîtier isolant (190) et logée
dans le second espace allongé (220).

3. Fiche de couplage de détection de tension (1) selon l'une quelconque des revendications précédentes, dans laquelle la partie d'accouplement (280) est adaptée pour être utilisée dans une interface de type A1, B1, B2, C1 ou C2 selon les normes allemandes DIN EN 50180 ou DIN EN 50181, telles qu'en vigueur le 18 novembre 2019.

4. Fiche de couplage de détection de tension (1) selon l'une quelconque des revendications précédentes, dans laquelle le premier espace allongé (210) a une forme telle que sa longueur est supérieure à trois fois son diamètre.

5. Fiche de couplage de détection de tension (1) selon l'une quelconque des revendications précédentes, dans laquelle le premier espace allongé (210) est adapté pour recevoir une extrémité d'un câble d'alimentation haute tension ou moyenne tension (120).

6. Fiche de couplage de détection de tension (1) selon l'une quelconque des revendications précédentes, dans laquelle le premier espace allongé (210) est dépourvu d'une extrémité d'un câble d'alimentation haute tension ou moyenne tension (120).

7. Fiche de couplage de détection de tension (1) selon l'une quelconque des revendications précédentes, dans laquelle le premier espace allongé (210) est en communication avec le second espace allongé (220).

8. Fiche de couplage de détection de tension (1) selon l'une quelconque des revendications précédentes, dans laquelle le premier espace allongé (210) est en communication avec un extérieur du corps de fiche (160), et dans laquelle un fil de signal (310) rend le signal de tension disponible à l'extérieur du corps de fiche (160), le fil de signal allant du premier espace allongé (210) à l'extérieur du corps de fiche (160).

9. Fiche de couplage de détection de tension (1) selon l'une quelconque des revendications précédentes, dans laquelle le diviseur de tension (70) est entièrement logé dans le premier espace allongé (210).

10. Fiche de couplage de détection de tension (1) selon l'une quelconque des revendications précédentes, dans laquelle la pièce de contact (230) fait saillie dans le premier espace allongé (210).

11. Fiche de couplage de détection de tension (1) selon l'une quelconque des revendications précédentes, dans laquelle la pièce de contact (230) est accessible de l'extérieur par le biais du second espace allongé (220).

12. Fiche de couplage de détection de tension (1) selon l'une quelconque des revendications précédentes, dans laquelle la pluralité d'éléments d'impédance discrets (30) consiste en dix condensateurs discrets (30) ou plus, ou en dix résistances discrètes ou plus, ou en dix inducteurs discrets ou plus.

13. Fiche de couplage de détection de tension (1) selon l'une quelconque des revendications précédentes, comprenant en outre un corps d'encapsulation rigide non conducteur (350) encapsulant la pluralité d'éléments d'impédance discrets (30).

14. Fiche de couplage de détection de tension (1) selon la revendication 13, comprenant en outre une couche de blindage conductrice (360), agencée sur une surface externe du corps d'encapsulation (350).

15. Fiche de couplage de détection de tension (1) selon l'une quelconque des revendications précédentes, comprenant en outre un manchon isolant tubulaire, élastiquement déformable (370), dans lequel manchon (370) le capteur de tension (11) est intégré.

16. Ensemble comprenant
a) un appareil de connexion (110) ou un transformateur dans un réseau électrique à haute tension ou moyenne tension d'un réseau national, l'appareil de connexion ou le transformateur comprenant une traversée (3) ;
b) un connecteur séparable haute tension ou moyenne tension (2), connecté électriquement et mécaniquement à l'appareil de connexion ou au transformateur par l'intermédiaire de la traversée ; et
c) une fiche de couplage de détection de tension (1) selon l'une quelconque des revendications précédentes, accouplée au connecteur séparable.

17. Réseau électrique, tel qu'un réseau national, comprenant un ensemble selon la revendication 16.
